Europäisches Patentamt

European Patent Office

Office européen des brevets

(11) Publication number: **0 198 702 B1**

(12) **EUROPEAN PATENT SPECIFICATION**

(45) Date of publication of patent specification: **05.02.92**

(51) Int. Cl.⁵: **G11B 20/18**, H03M 13/00, H03M 13/22

(21) Application number: **86302764.5**

(22) Date of filing: **14.04.86**

(54) Methods of correcting errors in digital data.

(30) Priority: **13.04.85 JP 78881/85**
**13.04.85 JP 78882/85**

(43) Date of publication of application:
**22.10.86 Bulletin 86/43**

(45) Publication of the grant of the patent:
**05.02.92 Bulletin 92/06**

(84) Designated Contracting States:
**DE FR GB NL**

(56) References cited:
**EP-A- 0 086 566**
**FR-A- 2 141 094**
**GB-A- 2 107 496**
**US-A- 4 413 339**

**IEEE TRANSACTIONS ON COMPUTERS, vol. C-33, no. 2, February 1984, pages 178-189, IEEE, New York, US; K.Y. LIU: "Architecture for VLSI design of Reed-Solomon decoders"**

**PATENT ABSTRACTS OF JAPAN, vol. 8, no. 245 (P-312)[1682], 10th November 1984; & JP-A-59 117 643 (FUJITSU K.K.) 07-07-1984**

(73) Proprietor: **SONY CORPORATION**
**7-35 Kitashinagawa 6-Chome Shinagawa-ku**
**Tokyo 141(JP)**

(72) Inventor: **Sako, Yoichiro c/o Patents Division**
**Sony Corporation 6-7-35 Kitashinagawa**
**Shinagawa-ku Tokyo 141(JP)**
Inventor: **Yamamura, Shinichi c/o Patents Division**
**Sony Corporation 6-7-35 Kitashinagawa**
**Shinagawa-ku Tokyo 141(JP)**
Inventor: **Arai, Masayuki c/o Patents Division**
**Sony Corporation 6-7-35 Kitashinagawa**
**Shinagawa-ku Tokyo 141(JP)**

(74) Representative: **Thomas, Christopher Hugo et al**
**D Young & Co 10 Staple Inn**
**London WC1V 7RD(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to methods of correcting errors in digital data, and more particularly, but not exclusively, to methods suitable for use in cases where interpolation is not appropriate.

When reading data from a storage device such as an optical disc or a magneto-optical disc, idle periods occur in the reading operation. One such period is the period preceding reading out of a signal from the storage device, and another period is a waiting time during which the storage device waits for an instruction, for example, from a control computer. The frequency and duration of such idle periods varies with the operations being performed.

While it has been proposed to perform error correction during these idle periods, the error correcting processes previously proposed have occupied a fixed time only, so that they may be stopped prematurely, before all the errors have been corrected.

For data stored on a compact disc, the so-called CIRC correction code is used as an error correction code, this CIRC correction code being a combination of a cross-interleaving and Reed Solomon codes. See, for example, our US patent specification US-A-4 413 340. In such a CIRC correction code, each symbol of the data is included in two series of error correction codes, referred to as the C1 series and the C2 series. Coding is first performed in the C2 series, and then an interleaving process is carried out with the further coding being performed in the C1 series. For the decoding, the inverse operation is performed, with decoding being performed in the C1 series, then the de-interleaving process is carried out, and further decoding is performed in the C2 series. In the case of the CIRC correction code, greater numbers of errors can be corrected by performing the error correcting process repetitively, using the C1 and C2 series.

When CIRC coding is used, a pointer or flag is used when decoding the C2 series, which indicates the error state following the decoding in the C1 series. Thus, the decoding in the C2 series is carried on in accordance with the number of pointers developed in the C1 series, or whether a pointer is set at an error location obtained by the decoding in the C1 series. In other words, an indication is provided as to whether a single symbol error has been corrected, a two symbol error has been corrected, or no error correction has taken place. The pointer is necessary in order to reduce errors at the time of the correction.

In the previously proposed error correcting method, the error correcting process is stopped after a fixed time, even although more time remains during an idle period. However, with an increase in the number of repetitions of the correcting process, the error correcting capability can be more fully utilized.

In addition, in this previously proposed error correcting method, a relatively long time is required to read out the code series from the storage device. This reduces the amount of time during which error correction can take place. Also, an additional circuit is required to determine the number of pointers which are needed, since the correcting method in the second coding series is altered in dependence on the number of pointers which are included in the first code series.

According to the present invention there is provided a method of correcting errors in digital data formed into blocks made up of a predetermined number of symbols to which a first and a second series of error correction codes have been added, the method comprising the steps of: repeatedly performing an error correcting process on the digital data of each block using said first and said second code series;
detecting the occurrence of a data request signal requesting the data of the block on which the error correcting process is being performed; and
terminating execution of said error correcting process in response to receipt of said data request signal.

The invention will now be described by way of example with reference to the accompanying drawings, throughout which like parts are referred to by like references, and in which:

Figure 1 is a diagram showing the recording format of a signal which is recorded in each sector of a storage device, such as a disc type storage device;

Figure 2 is a diagram illustrating operation of an error correction method, showing the production of a series of respective error correction codes for the data recorded in each sector;

Figure 3 is a block diagram of a signal reproducing circuit for performing an error correcting method according to the present invention, in connection with a disc type storage device;

Figure 4 is a block diagram of a decoder for performing error correction; and

Figure 5 is a flowchart of an error correcting method according to the present invention.

A preferred embodiment of the present invention will now be described for use with an optical disc storage device or a magneto-optical disc storage device, for correction of errors in data read from the disc.

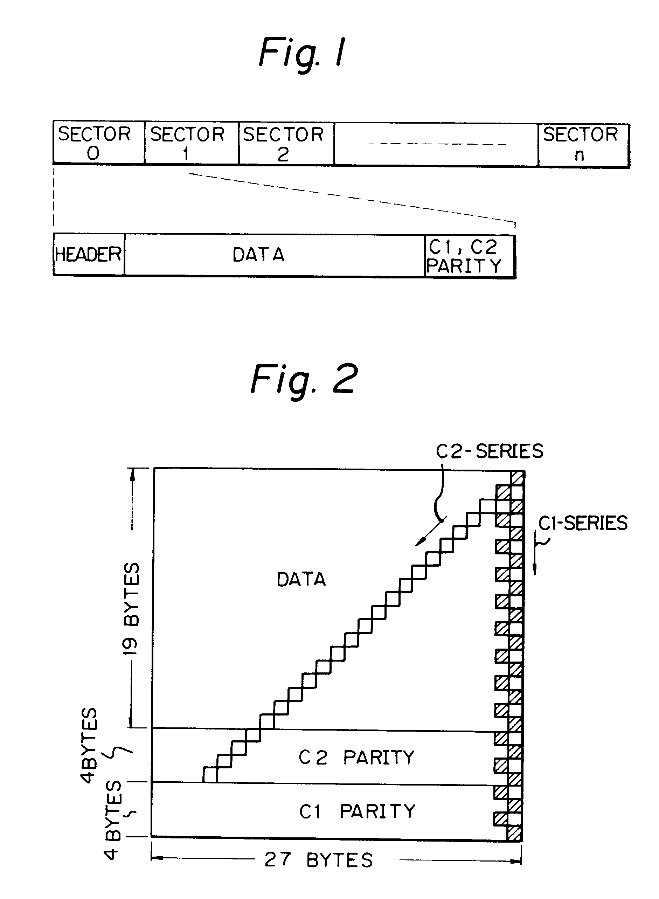

Figure 1 illustrates the format of digital signals recorded in each data sector on the disc recording medium. The sectors are recorded in series, and each sector incorporates a header which includes a synchronizing signal, an address signal, and the like. Following the header, the data area is provided, and at the end of the data area, a parity area is provided with parity codes forming error correction code series C1 and C2.

Figure 2 illustrates the relationship of error correction code series C1 and C2, which produce the respective parity codes for the data which are recorded in each sector. In the example Figure 2, one symbol of the data consists of one byte. Where the digital data are made up of a total of 513 bytes (19 bytes x 27 bytes), one byte indicates the sector number, and 512 bytes represent recorded data. These bytes are shown in a two-dimensional arrangement in Figure 2 in a 19 x 27 rectangle. The C1 series of parity codes are developed relative to the vertical dimension of the rectangle, and the C2 series of parity codes are developed in an oblique direction as illustrated in Figure 2.

The C2 parity code consists of four bytes, formed as the sum of 19 bytes of the data, taken in the oblique direction as shown in Figure 2. For example, (23, 19) Reed Solomon code is used for the C2 parity.

Similarly, the C1 parity consists of four bytes produced from data consisting of the 19 bytes of the 19 x 27 rectangle and four bytes of the C2 parity. For example, (27, 23) Reed Solomon code is used for the C1 parity. The C2 parity is taken in a zig-zag arrangement, as illustrated in Figure 2, indicating that it has been subjected to an interleaving process.

As described above, the parities of 216 bytes (4 x 27) for the C1 series and (4 x 27) for the C2 series are added to the data of 513 bytes, and the header forms an additional 104 bytes, making a total of 833 bytes recorded as each sector on the storage disc.

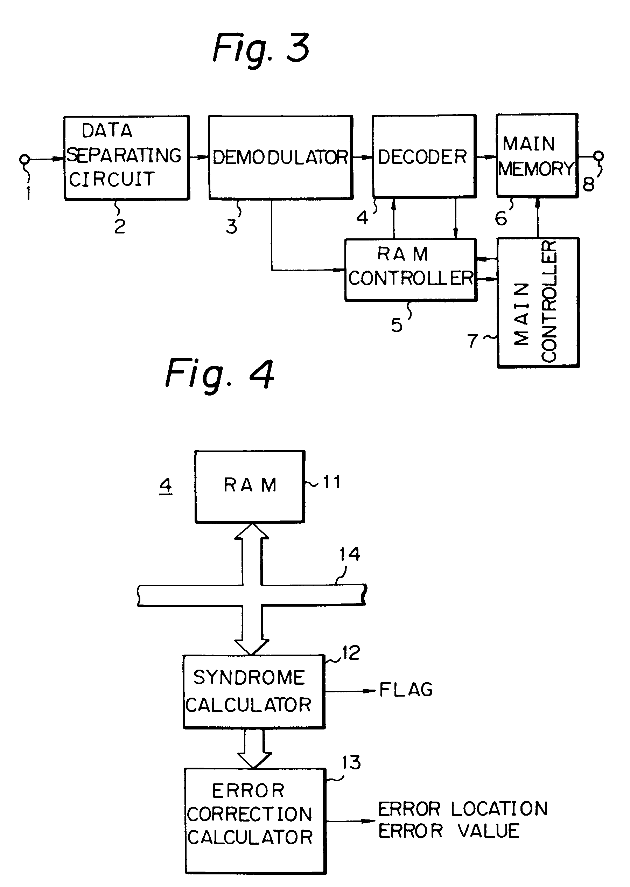

Figure 3 illustrates apparatus for reproducing a signal from the storage disc. A signal read from the disc at an input terminal 1 is supplied to the input of a data separating circuit 2 which shapes the waveform of the signal, separates the data, and supplies the data to a demodulator 3. The demodulator 3 demodulates the data which, during the recording process, were subjected to digital modulation, such as eight-fourteen modulation (EFM). The output of the demodulator 3 is supplied to the input of a decoder 4 which performs the error correcting process. A RAM controller 5 generates a control signal and an address signal and supplies these signals to the decoder 4. The address signal addresses a RAM which is included within the decoder 4. The decoder 4 executes the de-interleaving, using the signal supplied by the RAM controller 5. Error information is supplied from the decoder 4 to the RAM controller 5, such information indicating an error location, an error size or value, and the state of an error. The RAM controller 5 responds to the information received from the decoder 4, controls the RAM within the decoder 4, and reads out data which is identified as having an error.

A main memory 6 is connected to an output of the decoder 4, and the decoder 4 supplies to the main memory 6 the data which have been subjected to the error correcting process. A main controller 7 supplies a control signal to the main memory 6. Data read out from the main memory 6 are made available at an output terminal 8. The main controller 7 supplies a data request signal to the RAM controller 5 and in response to this data request signal, the decoded data stored in the main memory 6 is read out and made available at the terminal 8.

A data re-sending request signal may be supplied from the RAM controller 5 to the main controller 7. This signal is generated in the case where the error correction cannot be executed with the data as received. When the main controller 7 receives the data re-sending request signal, it controls the position of the read head of the disc storage device and again reads or reproduces the data recorded in the same sector, making this available at the input terminal 1.

Figure 4 illustrates the structure of the decoder 4 which performs the error correction process. A RAM 11 is provided, which stores a signal consisting of 729 bytes (27 x 27), consisting of the data and parity bytes recorded in each sector of the disc storage device. A common data bus 14 is provided and the RAM 11 and a syndrome calculator 12 are each connected to the bus 14. An error correction calculator 13 is connected to the syndrome calculator 12.

In the embodiment described, a Reed Solomon code is used as the error correction code. The syndrome calculator 12 employs the Chien algorithm for the syndrome calculation, and for the error correcting calculation based on the syndrome. The Chien algorithm has been described in detail in R T Chien, "Cyclic Decoding Procedure for Bose-Chaudhuri-HocquenghemCodes", IEEE Translations, IT-10, pp 357 to 363, 1964.

The syndrome calculator 12 executes a multiplication of the data of the C1 series or the C2 series read out from the RAM 11, with a preset parity check matrix, so that four syndromes $S_0$, $S_1$, $S_2$ and $S_3$ are produced. The quantities A, B and C in the following expressions are obtained from the four syndromes, respectively.

$$A = S_0 S_2 + S_1^2$$
$$B = S_1 S_2 + S_0 S_3$$
$$C = S_1 S_3 + S_2^2$$

The syndrome calculator 12 inspects the state of the quantities A, B and C to determine the error state. In the case of no error:

$$S_0 = 0, S_3 = 0, A = B = C = 0$$

In the case of one error:

$$S_0 \neq 0, S_3 \neq 0, A = B = C = 0$$

In the case of two errors:

$$A \neq 0, B \neq 0, C \neq 0$$

In the case of three or more errors a different series of outputs is produced.

In the above example, it has been assumed that one or two errors can be corrected in the C1 or C2 errors. The syndrome calculator 12 (Figure 4) generates a pointer or flag indicating the state of the error. The syndromes formed by the calculator 12 are supplied to the error correction calculator 13. The error correction is carried out by the error correction calculator 13 by obtaining the error location and the error value. The algorithm used for the correcting calculation is the same one used in the familar digital audio disc reproducing apparatus.

The error location and error value produced by the error correction calculator 13 are used for the correcting calculation and are also supplied to the RAM controller 5.

The error correcting process will now be described. The data of the C1 series are read out from the RAM 11 and are subjected to the error correction by the syndrome calculator 12 and the error correction calculator 13. If necessary, the C2 series, having been subjected to the de-interleaving process, is read out from the RAM 11 and is error corrected by the calculators 12 and 13.

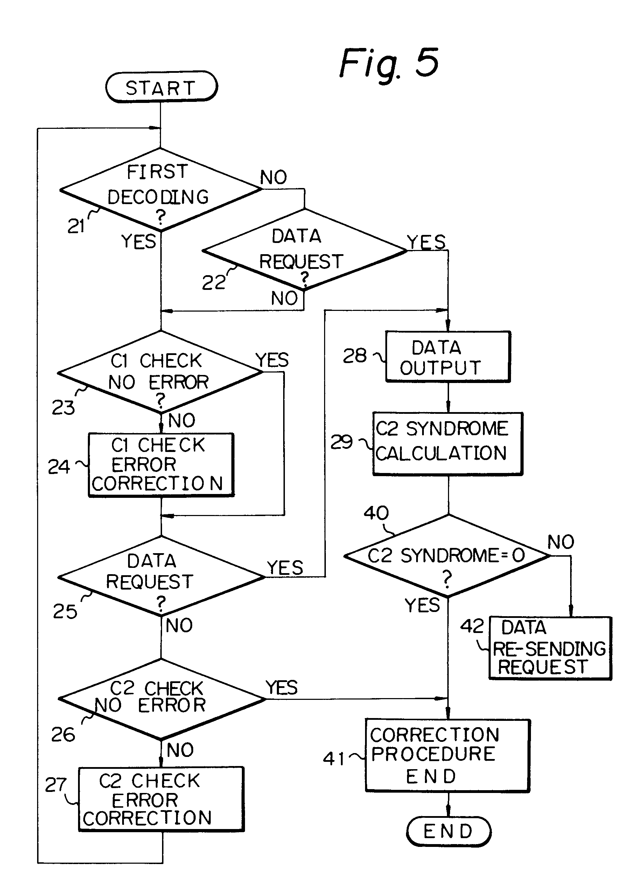

By repeatedly executing the error correcting process using the C1 series and the C2 series, the number of symbols which can be corrected increases. The sequence of operations performed during the decoding operation will be described with reference to Figure 5.

The steps illustrated in the flowchart of Figure 5 are performed under the control of the RAM controller 5. When the sequence of Figure 5 receives control, a check is first made in step 21 to determine whether this is the first decoding or not. If not, then a check is made in step 22 to determine if a data request signal has been received. Such a data request signal is supplied from the main controller 7 to the RAM controller 5. If a data request signal has been received, the digital data, after completion of the error correction, is read out from the RAM 11 and the decoder 4 and stored in the main memory 6.

When the step 21 determines that it is the first decoding has already taken place, then control passes to a step 23, and the C1 decoding is carried out, by reading out the syndrome of the C1 series, from the RAM 11 to the syndrome calculator 12, and then a check is made to determine whether or not an error has been detected. All of these functions are carried out in the step 23.

If an error is detected by the unit 23, then control passes to a step 24, and error correcting for the C1 series is performed. Then control passes to a step 25. If no error is detected by the step 23, then control passes directly to the step 25.

The step 25 determines whether a data request signal has been received. If not, a step 26 receives control and the C2 series is processed for error correction. This involves reading out the C2 series from the RAM 11 to the syndrome calculator 12, and after operation of the calculators 12 and 13, checking to see whether an error is detected. If an error is detected, control passes to a step 27, which performs the error correction on the C2 series. If the step 26 determines that no error has occurred, then the correcting operation of the step 27 is not executed.

When the error correction is completed by the step 27, control returns to the step 21, and the above sequence is repeated.

If a data request signal is identified by the steps 22 or 25, then control passes to a step 28 which sends the data in response to the received data request. Thus, the data, after completion of error correction, are sent to the main memory 6, from the RAM 11 within the decoder 4. After the data have been read out from the RAM 11, a step 29 receives control and calculates the syndrome for the C2 series, and then a step 40 receives control to determine if the calculated syndrome is 0. The C1 series may optionally also be used in this calculation if desired. If the step 40 determines that no error has been detected, with the syndrome being equal to 0, then the current data may be handled as the effective data. A step 41 receives control to finish the correcting operation, and pass control on to another sequence. If the step 40 determines that an error has occurred, then the data are invalidated and a step 42 receives control to cause the RAM controller 5 to issue a re-send request signal to the main controller 7. In response to the re-send request, the data are again read out from the same sector on the disc, and the procedure is repeated.

After the error check-correcting operation has been performed once with the C1 series and the C2 series, then further error detecting and correcting operations are carried out in connection with the C1 and C2 series repeatedly during the entire time available, until a data request signal is received. This gives the maximum chance of finding and correcting all errors by the time data request is received, so that error-free data can be supplied in response to such request.

In an optional modification of the embodiment described above, a b-adjacent code or the like may be used instead of the Reed Solomon code. Also, although two series of respectively vertical and oblique directions have been described in connection with Figure 2, for the C1 and C2 series, other directions may be substituted if desired.

In addition, if it is determined that no errors are detected in the data in the operation of decoding the first series, then the data may be accepted without performing decoding of the other series.

The process is performed by repeatedly using the C1 and C2 series, individually, without referring to the result of the error correction of the other series. Thus, the error correcting processes are carried out mutually independently, and the process is not delayed by having to deal with pointers set by preceding processes.

## Claims

1. A method of correcting errors in digital data formed into blocks made up of a predetermined number of symbols to which a first and a second series of error correction codes have been added, the method comprising the steps of:
   repeatedly performing an error correcting process on the digital data of each block using said first and said second code series;
   detecting the occurrence of a data request signal requesting the data of the block on which the error correcting process is being performed; and
   terminating execution of said error correcting process in response to receipt of said data request signal.

2. A method according to claim 1 including the step of alternately using said first and said second code series in said error correcting process.

3. A method according to claim 2 wherein said error correcting process using each of said first and second code series does so without reference to the result of previous error correction.

4. A method according to claim 1, claim 2 or claim 3 including the step of determining if no error was detected during performance of said error correcting process using said first and said second code series.

5. A method according to claim 4 including the step of issuing a request for a new supply of said data block in response to detection of an error during performance of said error correcting process.

## Revendications

1. Méthode de correction d'erreurs dans des données numériques formées en blocs constitués d'un nombre prédéterminé de symboles auxquels une première et une deuxième série de codes de correction d'erreurs ont été ajoutées, la méthode comprenant les étapes qui consistent à:
   exécuter d'une façon répétitive une opération de correction d'erreurs sur les données numériques de chaque bloc par la mise en oeuvre desdites première et deuxième séries de codes;
   détecter l'apparition d'un signal de demande de données demandant les données du bloc sur lequel l'opération de correction d'erreurs est exécutée; et à
   terminer l'exécution de ladite opération de correction d'erreurs en réponse à la réception dudit signal de demande de données.

2. Méthode selon la revendication 1, incluant l'étape qui consiste à utiliser alternativement ladite première série de codes et ladite deuxième série de codes dans ladite opération de correction d'erreurs.

3. Méthode selon la revendication 2, dans laquelle ladite opération de correction d'erreurs utilisant chacune desdites première et deuxième séries de codes le fait sans référence au résultat de la correction d'erreurs précédente.

4. Méthode selon l'une quelconque des revendications 1 à 3, incluant l'étape qui consiste à déterminer si aucune erreur n'a été détectée pendant l'exécution de ladite opération de correction d'erreurs utilisant lesdites première et deuxième séries de codes.

5. Méthode selon la revendication 4, incluant l'étape qui consiste à émettre une demande pour une nouvelle fourniture dudit bloc de données en réponse à la détection d'une erreur pendant l'exécution de ladite opération de correction d'erreurs.

## Patentansprüche

1. Verfahren zum Korrigieren von Fehlern in digitalen Daten, die in Blöcken angeordnet sind, die aus einer vorbestimmten Anzahl von Symbolen bestehen, denen eine erste und eine zweite Reihe von Fehlerkorrekturkodes hinzugefügt sind, mit den Verfahrensschritten:

wiederholtes Durchführen eines Fehlerkorrekturprozesses an den digitalen Daten jedes Blocks unter Verwendung der ersten und der zweiten Kodereihe,

Feststellen des Auftretens eines Datenanforderungssignals, mit dem die Daten des Blocks angefordert werden, an dem gerade der Fehlerkorrekturprozeß durchgeführt wird, und

Beenden der Durchführung des Fehlerkorrekturprozesses als Reaktion auf den Empfang des Datenanforderungssignals.

2. Verfahren nach Anspruch 1 mit dem Verfahrensschritt der abwechselnden Benutzung der ersten und der zweiten Kodereihe in dem Fehlerkorrekturprozeß.

3. Verfahren nach Anspruch 2, bei dem der Fehlerkorrekturprozeß, der die erste und die zweite Kodereihe verwendet, dies ohne Bezugnahme auf das Ergebnis der vorangehenden Fehlerkorrektur tut.

4. Verfahren nach Anspruch 1, 2 oder 3 mit dem Verfahrensschritt, daß festgestellt wird, ob während der Durchführung des Fehlerkorrekturprozesses unter Verwendung der ersten und der zweiten Kodereihe kein Fehler festgestellt wurde.

5. Verfahren nach Anspruch 4 mit dem Verfahrensschritt, daß als Reaktion auf die Erfassung eines Fehlers während der Durchführung des Fehlerkorrekturprozesses eine Anforderung für eine erneute Zuführung des Datenblocks abgegeben wird.

# Fig. I

| SECTOR 0 | SECTOR 1 | SECTOR 2 | ------- | SECTOR n |
|---|---|---|---|---|

| HEADER | DATA | C1, C2 PARITY |
|---|---|---|

# Fig. 2

C2-SERIES

C1-SERIES

19 BYTES

DATA

4 BYTES

C 2 PARITY

4 BYTES

C1 PARITY

27 BYTES

# Fig. 3

```
          ┌──────────┐   ┌───────────┐   ┌─────────┐   ┌─────────┐
          │  DATA    │   │           │   │         │   │  MAIN   │
  o──────▶│SEPARATING│──▶│DEMODULATOR│──▶│ DECODER │──▶│ MEMORY  │───o
          │ CIRCUIT  │   │           │   │         │   │         │  8
          └──────────┘   └───────────┘   └─────────┘   └─────────┘
   1            2              3              4            6
                                    │         ▲    │        ▲
                                    │         │    ▼        │
                                    │      ┌─────────────┐  │
                                    │      │    R A M    │◀─┤
                                    └─────▶│  CONTROLLER │  │  MAIN
                                           └─────────────┘◀─┤CONTROLLER
                                                  5         7
```

# Fig. 4

```
           ┌──────────────┐
    4       │    R A M     │~11
           └──────────────┘
                  ▲
                  │
                  ▼                    14
         ═══════════════════════════════╗
         ═══════════════════════════════╝
                  │
                  ▼
           ┌──────────────┐ 12
           │  SYNDROME    │────▶ FLAG
           │ CALCULATOR   │
           └──────────────┘
                  │
                  ▼
           ┌──────────────┐ 13
           │    ERROR     │
           │ CORRECTION   │────▶ ERROR LOCATION
           │ CALCULATOR   │      ERROR VALUE
           └──────────────┘
```

# Fig. 5

START

21 FIRST DECODING ? — NO
YES

22 DATA REQUEST ? — YES
NO

23 C1 CHECK NO ERROR ? — YES
NO

24 C1 CHECK ERROR CORRECTION

25 DATA REQUEST ? — YES
NO

26 C2 CHECK NO ERROR — YES
NO

27 C2 CHECK ERROR CORRECTION

28 DATA OUTPUT

29 C2 SYNDROME CALCULATION

40 C2 SYNDROME=O ? — NO
YES

42 DATA RE-SENDING REQUEST

41 CORRECTION PROCEDURE END

END